# EUROPEAN PATENT SPECIFICATION

(11) **EP 2 533 272 B1**
(45) Date of publication and mention of the grant of the patent: **12.03.2014**
(21) Application number: 12171198.0
(22) Date of filing: 07.06.2012
(51) Int. Cl.: C25D 17/12, H01L 21/288

(54) **An ecpr master electrode, and a method for providing such master electrode**
ECPR-Masterelektrode und Verfahren zur Bereitstellung solch einer Masterelektrode
Électrode maître ECPR et procédé permettant de fournir une telle électrode maître

(30) Priority: 07.06.2011 EP 11290259
(43) Date of publication of application: 12.12.2012
(73) Proprietor: Centre de Recherche Public - Gabriel Lippmann, 4422 Belvaux (LU)
(72) Inventor: Aronsson, Cecilia, 174 47 SUNDBYBERG (SE); Corlevi, Silvia, 181 56 LIDINGÖ (SE); Cuthbertson, Alan, 69410 Champagne au Mont d'or (FR); Fredenberg, Mikael, 112 45 STOCKHOLM (SE); Kennedy, Tim, 38000 GRENOBLE (FR); Möller, Patrik, 112 32 STOCKHOLM (SE); Dainese, Matteo, 38000 GRENOBLE (FR)
(74) Representative: Wagner, Jean-Paul

(56) References cited:
- JP-A- 2005 256 110
- US-A1- 2004 182 716

## Description

### FIELD OF THE INVENTION

The present invention relates to an ECPR master electrode, and a method for providing such master electrode. More particularly, the present invention relates to a circular ECPR master electrode.

### BACKGROUND ART

WO 02/103085 and WO 2007058603 relate to an electrochemical pattern replication process, ECPR, and the construction of a master electrode for production of appliances involving micro and nano structures using ECPR. An etching or plating pattern, which is defined by the master electrode, is replicated on an electrically conductive material, commonly denoted as a substrate. During ECPR, the master electrode is put in close contact with the substrate and the etching/plating pattern is directly transferred onto the substrate by an etching/plating process. The contact etching/plating process is performed in local etching/plating cells, which are formed in cavities between the master electrode and the substrate.

The cavities are provided as electrochemical cells having an open end at the upper surface of the master electrode, and extending downwards. Hence, the upper surface of the master electrode includes a topographical pattern defining at least one electrochemical cell, wherein the bottom of each cell is provided with an electrically conducting material. During ECPR, each cell is filled with an electrolyte solution, for allowing conducting ions of the conducting material to be transferred from the bottom of each cell to the substrate to be patterned.

The area between the electrochemical cells, i.e. the uppermost area of the topographical pattern of the master electrode is provided with an insulating layer for preventing unwanted parasitic currents during the ECPR process. Hence, ECPR will only provide pattern transfer at the positions being defined by the electrochemical cells.

Before the master electrode is used in the ECPR, the electrochemical cells need to be prefilled with a conductive material. Usually, the thickness of the prefilled material is in the range of 0,5 to 10 micrometers, depending on the specific application. During the ECPR the conductive material is transferred from the bottom of the electrochemical cells of the master electrode to the substrate being plated. Thus, when the master electrode is separated from the processed substrate the prefilled conductive material is arranged on the substrate.

The master electrode may be made of a carrier element of a durable material, since the master electrode should be used for a plurality of processes of etching or plating. One such material is Si, which allows the master electrode to be manufactured by well established and high yield semiconductor processes. Consequently, in many cases circular Si wafers form the carrier elements of ECPR master electrodes.

For the chip industry, the topographical pattern of the master electrode may be arranged in a planar distribution across the master electrode surface, wherein the planar distribution includes a number of rectangular sub-areas. In such application, each rectangular sub-area may define a chip. Hence, the master electrode may be provided with a topographical pattern being periodic and defining a plurality of adjacently arranged rectangular chips. The rectangular shape of each chip is usually necessary because of the need for facilitated dicing and chip separation later in the device manufacturing process.

During ECPR, current will flow radially through the master electrode to the seeded substrate and out via an external connection at the edge of the substrate. If the pattern density across the master electrode is exhibiting variations close to the edge of the circular carrier element, this may result in uneven plating thickness across the substrate being processed by ECPR due to non-uniform current flow. Thus, the chips having a position corresponding to the central part of the master electrode will be different from the chips having a position corresponding to the more peripheral part of the master electrode. Quality may therefore vary between different chips.

US 2004/0182716 describes a conformable contact mask for electroplating. The mask has die-pattern regions and may be passivated in its peripheral region against inducing treatment to a substrate, by a dielectric or shielding material.

### SUMMARY OF THE INVENTION

Accordingly, the present invention seeks to mitigate, alleviate or eliminate one or more of the above-identified deficiencies and to provide an improved ECPR master electrode as well as a method for manufacturing such master electrode.

It is an object of the present invention to provide a circular ECPR master electrode to be used in rectangular chip fabrication.

It is a further object of the present invention to provide a method for manufacturing such master electrode using a simple lithographic process, which may be done by standard semiconductor process equipment.

It is a further object of the present invention to provide a method for manufacturing such master electrode while allowing for uniform quality of the manufactured chips.

It is an idea of the present invention to provide a circular ECPR master electrode having a topographical pattern defining electrochemical cells arranged in a periodic rectangular pattern, and a passivated area at the periphery of said topographical pattern such that said topographical pattern has a circular distribution.

According to a first aspect of the invention a method for providing an ECPR master electrode is provided. The method comprises the step of providing a circular carrier element having an electrically conducting electrode surface on a back side and a topographical pattern with an at least partly electrically insulating top on a front side of said carrier element, said topographical pattern comprising a plurality of electrochemical cells in said carrier element, each one of said electrochemical cells comprising a bottom and at least one side wall, said bottom having an electrically conducting surface being conductively connected to the electrically conducting electrode surface on the back side through the carrier element, wherein the step of providing said topographical pattern comprises distributing said topographical pattern across a device area extending radially from the centre of the carrier element towards the periphery of said carrier element, and passivating a peripheral part of said device area by arranging an electrically insulating layer on top of said peripheral part of said device area.

Distributing the topographical pattern across a device area may comprise providing a plurality of rectangular chip areas, each chip area is forming a portion of said topographical pattern. Distributing the topographical pattern across a device area may further comprise covering the complete front side of said carrier element with said topographical pattern. Hence, scanner or stepper technology may be used for defining the topographical pattern.

The step of passivating a peripheral part of said device area may comprise providing an oxide mask on top of a portion of said device area; oxidizing said front side of said carrier element; and removing said oxide mask from said device area. Providing an oxide mask may comprise providing a first layer of silicon nitride on top of said device area; providing a resist layer on top of said layer of silicon nitride; removing a peripheral part of said resist layer; and etching through the first layer of silicon nitride using the remaining resist layer as an etch mask. This is advantageous in that the passivation is achieved with good selectivity and simple processing, since the steps used are commonly known within the semiconducting industry.

The step of etching through the first layer of silicon nitride may be performed by an anisotropic process. Hence, accurate transfer of patterns is provided.

The method may further comprise the step of providing an annular recess at said peripheral part, which is advantageous in that enough room is provided for contacting the substrate during ECPR.

According to a second aspect, and ECPR master electrode is provided. The master electrode comprises a circular carrier element having an electrically conducting electrode surface on a back side and a topographical pattern with an at least partly electrically insulating top on a front side of said carrier element, said topographical pattern comprising a plurality of electrochemical cells in said carrier element, each one of said electrochemical cells comprising a bottom and at least one side wall, said bottom having an electrically conducting surface being conductively connected to the electrically conducting electrode surface on the back side through the carrier element, wherein said topographical pattern is distributed across a circular device area comprising a plurality of rectangular chip areas, and a passivated area surrounding said device area.

Said passivated area may comprise an oxide layer on top of said topographical pattern.

The carrier element may comprise an annular recess outside the passivated area.

Said annular recess may extend from the outer circular periphery of the passivated area to the edge of the carrier element.

The advantages of the first aspect of the invention are also applicable for the second aspect of the invention.

### BRIEF DESCRIPTION OF THE DRAWINGS

Hereinafter, the invention will be described with reference to the appended drawings, wherein:
Fig. 1 is a top view of an ECPR master electrode according to an embodiment;
Fig. 2 is a side view of a master electrode and a substrate during ECPR; and
Fig. 3a-g show the manufacturing process of a master electrode according to an embodiment.

### DESCRIPTION OF EMBODIMENTS

Below, several embodiments of the invention will be described with references to the drawings. These embodiments are described in illustrating purpose in order to enable a skilled person to carry out the invention and to disclose the best mode.

Some general remarks are given below with regard to the master electrode and methods of forming the master electrode. Several methods are described for forming a master electrode that can be used for producing one or multiple layers of structures of one or multiple materials including using the ECPR technology described below. The methods generally include: forming a master electrode from a carrier element which is conducting and/or semiconducting in at least some parts; forming a conducting electrode layer which functions as anode in ECPR plating and cathode in ECPR etching on a front side of the master electrode; and forming an insulating pattern layer that defines the cavities in which ECPR etching or plating can occur in the ECPR process on said front side, such that conducting electrode surface(s) is/are obtained in the bottom of the cavities; in a way that makes possible electrical contact from an external power supply to the back side of the master electrode for allowing electron transfer through the master electrode to the front side thereof to the conducing electrode surface(s), such that said surface(s) will constitute anode(s) in ECPR plating and cathode(s) in ECPR etching.

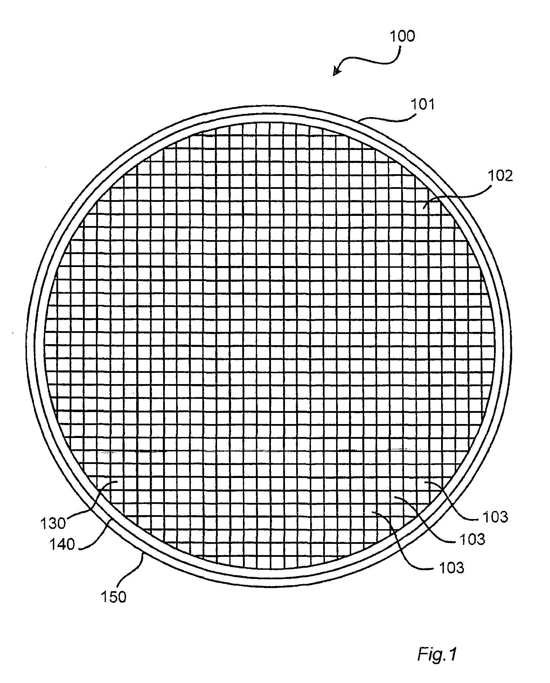

Now referring to Fig. 1, a top view of a master electrode 100 is shown. The master electrode 100 is formed by an at least partly electrically semiconducting circular carrier element 101, such as a Si wafer. The size of the carrier element may vary depending on the dimensions of the ECPR equipment to be used, but is typically of the size of standard semiconducting wafers, such as 100, 150, 200, 250, or 300 mm (4, 6, 8, 10, or 12 inches) in diameter. The upper surface 102, or front side of the master electrode 100 is divided into a plurality of rectangular segments 103, each segment 103 defining a device pattern, such as a chip layer, to be transferred to a substrate during an ECPR process.

The distribution of the rectangular segments 103 forms a device area 130 which is terminated by a circular periphery forming an interface to a surrounding passivated area 140, having an annular shape. The passivated area 140 is formed by oxidizing the outer part of the device area 130, such that the topographical pattern of the outer part of the device area 130 is provided with an oxide layer for preventing plating at this region.

The passivated area is surrounded by an edge region 150 being recessed relative the device area and the passivated area. The recessed part 119 of the carrier element 101 is formed in order to provide enough space for arranging an electrode (not shown) to provide electrical contact to the edge of the substrate to be plated during ECPR, without touching or damaging the master electrode. Furthermore, the surfaces of the recessed region 119 are passivated with an insulating material such as silicon dioxide or silicon nitride so that the electrodes connected to the substrate are not electrically connected to the master electrode.

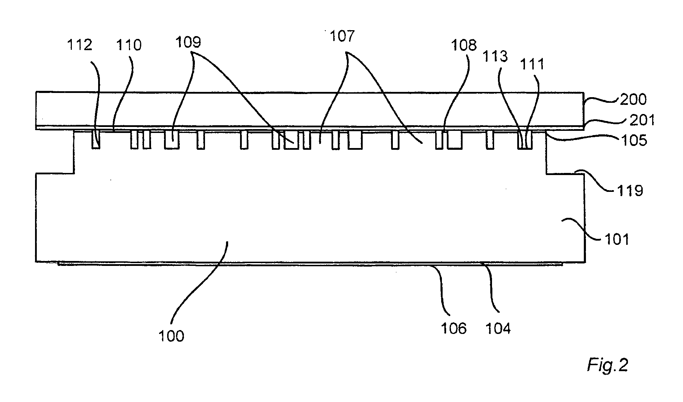

Now turning to Fig. 2, a side view of the master electrode 100 is schematically shown when arranged in close contact with a substrate 200 to be plated during ECPR. It should be noted that the master electrode and the substrate shown in this figure are not to scale, but shown only to illustrate different features in a suitable way. The carrier element 101 extends between a back side 104 and a front side 105, in such a way that electrical current is able to flow between the back side 104 and the front side 105. At the back side 104, an electrode layer 106 of an electrically conducting material is arranged. The electrode layer 106 may be formed by nickel silicide, or any other conducting material being suitable for a back side electrode layer during ECPR.

The front side 105 comprises a topographical pattern 107 with an at least partly electrically insulating top 108. The topographical pattern 107 is forming a plurality of electrochemical cells 109. That is, the planar surface extending between two adjacent electrochemical cells 109 is covered by an electrically insulating layer 110.

Each electrochemical cell comprises a bottom 111 and at least one side wall 112 extending from the bottom 111 to the electrically insulating top 108. The sidewall of the cavity is covered with an electrically insulating layer which extends from the surface insulating layer 110 to the point at which the sidewall meets the bottom of the cavity 111. The bottom 111 has an electrically conducting surface 113 being conductively connected to the electrically conducting electrode surface 106 on the back side 104 by means of the carrier element 101. Thus, the carrier element 101 is disposed between the conducting electrode surface 106 and the electrically conducting surface 113. The conductive surface 113 is formed by any material being suitable as an anode/cathode in the ECPR. Preferably, the conductive surface 113 may be formed by a self-aligned silicidation process.

The topographical pattern 107 extends from the center of the carrier element 101 radially towards the edge of the carrier element 101 and ends at a circular periphery arranged at a specific distance from the edge of the carrier element. The outer area 119 of the carrier element 101 not being occupied by the topographical pattern 107 is recessed such that the outer area is not in close contact with a substrate during ECPR. Preferably, the radial distance between the outer periphery of the topographical pattern 107 and the edge of the carrier element 101 is between 2.5 mm and 10 mm, and the width of the recessed part 119 of the carrier element is preferably 2 to 5 mm. The annular recess 119 is formed by using a resist mask and a deep silicon etch or by mechanical grinding or dicing of the carrier element 101. Preferably the depth of the recess region 119 is between 100 and 200 microns deep. The recessed part 119 of the carrier element 101 is formed in order to provide enough space for arranging an electrode at the edge of the substrate to be plated during ECPR, without touching or damaging the master electrode.

The surfaces of the region outside of the topological pattern 107 including the recessed portion 119 of the carrier element and the edge of the carrier element 101 are passivated with an electrically insulating material. This prevents unwanted parasitic current flowing at the edges of carrier during the ECPR pattern transfer.

During ECPR, the master electrode 100 is put in close contact with a substrate 200 to be plated. The substrate 200 is provided with a seed layer 201 of electrically conductive material, such that conductive ions may be plated onto said seed layer 201.

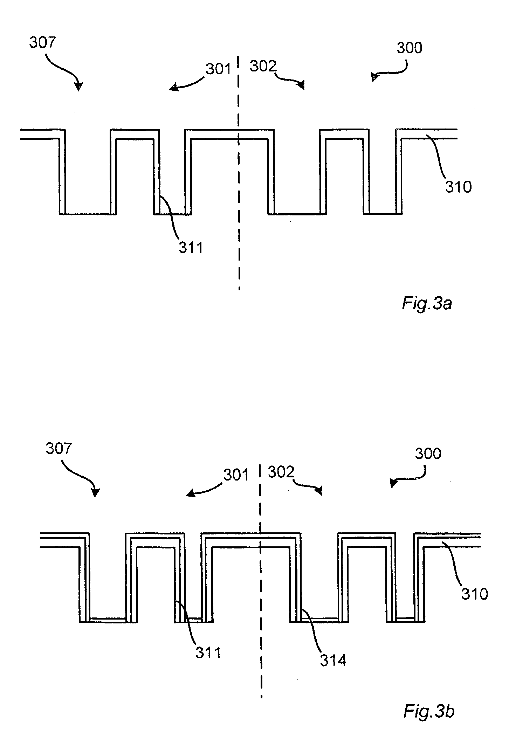

Now turning to Figs. 3a-g, side views of an ECPR master electrode 300 are shown. The master electrode 300 has a topographical pattern 307 on the front side, i.e. the side of the master electrode 300 that will face the substrate to be plated during ECPR. The topographical pattern 307 is distributed circularly across a device area 301. The device area 301 comprises a plurality of adjacently arranged rectangular chips which extend towards the edge of the master electrode. At the edge of the carrier element a recessed region is formed in accordance with what has previously been described.

The passivated area 302 of the topographical pattern 307 comprises a distribution of cavities in which the conduction path through the electrolyte is blocked. In these cavities a selectively grown thermal oxide prevents formation of the conductive layer in the bottom of the cavities. Hence in the passivated area no ECPR transfer takes place even though there is electrolyte in the cavities of the electrochemical cells. The pattern transfer during the ECPR process is thus defined entirely by the circular device area 301.

Said electrochemical cells of the passivated area 302 may be defined using a circular mask or lithographic edge bead removal process, which will be described in further details below. The thickness of the oxide is preferably in the range 500nm to 1000nm. Consequently, the current flow will be uniform at the edge of the device area 301 during ECPR, and the plating thickness will thus be homogenous over the complete device area 301.

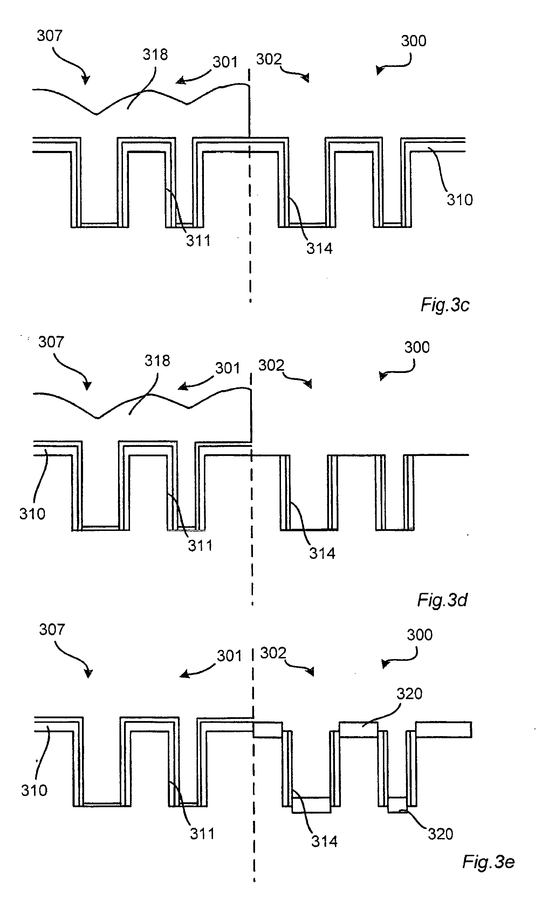

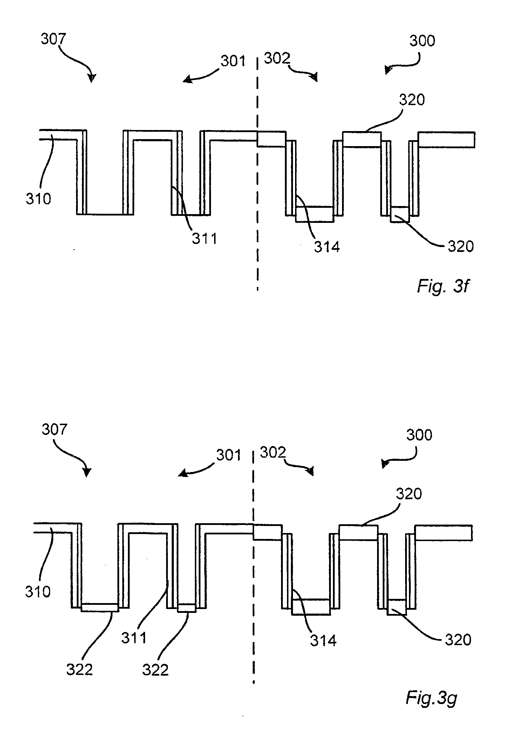

The master electrode 300 of Fig. 3 is preferably manufactured by a lithographic process involving two separate exposure steps. At a first step, shown in Fig. 3a, the device area 301 is provided by stepper technology, which is a well established process for providing rectangular chip pattern on a semiconducting carrier element, such as a Si wafer. A stepper or scanner may here be used for providing the chip pattern with low defectivity and high resolution such that the topographic pattern 307 defining the chips extends to the edge of the carrier element.

Figure 3a further shows representative cells or cavities of the topographic pattern 307 in the carrier element. The surface of the carrier element is passivated with insulating material 310 and the sidewalls of the cavities with a further insulating material 311 such that the complete front surface of the carrier element, except for the area of the bottom of each cell, is covered by said insulating material. Preferably, the insulating material 310 is also used as an etch mask during the provision of the electrochemical cells.

An edge bead removal process during the lithographic process commonly defines the proximity of the device area 301 to the edge of the master electrode which is typically in the range of 1 to 4 mm from the edge. Referring back to figure 3a, four cavities, which later will be processed as electrochemical cells, are shown. The cavities on the left side of the dashed line lie within the device area 303 while the cavities on the right side of the dashed line lie within the passivated area 302.

In order to create a circular termination to the pattern 303 a third layer 314, preferably CVD silicon nitride, is first deposited as shown in Fig. 3b. Silicon nitride is a commonly used semiconductor material and provides a film with excellent step coverage and extremely high resistance to thermal oxidation.

Referring to Fig. 3c, as a subsequent step, a second lithographic process is used for defining the circular periphery of the passivated area 302. This step is performed by coating a thick layer of resist 318 on the front side of the carrier element, and a subsequent exposure and development of the outer periphery of the master electrode. During this step, the thickness of the resist 318 should preferably be sufficient to at least partially fill the depth of the topographical pattern 307.

In order to create a circular resist pattern the photoresist may be exposed with a mask aligner using a circular chrome pattern on the mask.

A further method of achieving the cicular pattern in the thick photoresist may be to use an optical or chemical edge bead removal process commonly found on spin coater type semiconductor equipment.

After the resist is patterned the silicon nitride is then etched using e.g. a RIE etch tool. The RIE etch removes the silicon nitride in the bottom of the trenches and the surface dielectrics as shown in Fig. 3d. This type of etch is highly anisotropic and does not attack the silicon nitride on the sidewalls of the cavities.

After etching the silicon nitride and stripping of the photoresist the carrier element of the master electrode 300 may be subjected to a high temperature oxidation process as shown in Fig. 3e. The preferred thickness of this thermal oxide 320 is in the range 500-1000 nm, although other thicknesses of course may be considered as well. The silicon nitride layer 314 will prevent oxidation of the central portion of the master electrode 300, i.e. the device area 301, while the outer portion of the master electrode 300, i.e. the passivated area 302, will be oxidized. At the same time, the recessed region of the master electrode 300 and the bevel/edge of the carrier element will be oxidized.

In the following steps the conducting layer is formed in the cavities for forming the electrochemical cells of the topographic pattern 307. The silicon nitride layer 314 of the device area 301 is first removed using e.g. an unmasked or blanket RIE process as depicted in Fig. 3f. The thermally grown oxide 312 on the surface of the master electrode 300, as well as the oxide 320 arranged in the bottom of the cavities outside the device area 301 is etched only slightly during this etch process. This is due to the very large differential thicknesses and the chemistry used in the RIE process, which provides high SiN to SiO₂ selectivity. The thick thermal oxide 320 will block the formation of the conductive layer 322 in the bottom of the cavities as shown in Fig. 3g.

It is readily understood that all references to lower/upper are merely for illustrative purposes. Also, it should be noted that the dimensions of the different features and layers shown in the figures are not to scale, but should be interpreted only for illustrative purpose. All references in this application to actual values, such as layer thicknesses etc, should also only be read as examples of suitable dimensions.

In the claims, the term "comprises/comprising" does not exclude the presence of other elements or steps. Additionally, although individual features may be included in different claims, these may possibly advantageously be combined, and the inclusion in different claims does not imply that a combination of features is not feasible and/or advantageous. In addition, singular references do not exclude a plurality. The terms "a", "an", "first", "second" etc do not preclude a plurality. Reference signs in the claims are provided merely as a clarifying example.

## Claims

1. A method for providing an ECPR master electrode, comprising the step of:
providing a circular carrier element having an electrically conducting electrode surface on a back side and a topographical pattern with an at least partly electrically insulating top on a front side of said carrier element, said topographical pattern comprising a plurality of electrochemical cells in said carrier element, each one of said electrochemical cells comprising a bottom and at least one side wall, said bottom having an electrically conducting surface being conductively connected to the electrically conducting electrode surface on the back side through the carrier element,
wherein the step of providing said topographical pattern comprises:
distributing said topographical pattern across a device area extending radially from the centre of the carrier element towards the periphery of said carrier element, and
passivating a peripheral part of said device area by arranging an electrically insulating layer on top of said peripheral part of said device area.

2. The method according to claim 1, wherein said electrically insulating layer is an oxide layer.

3. The method according to claim 1 or 2, wherein distributing the topographical pattern across a device area comprises providing a plurality of rectangular chip areas, each chip area is forming a portion of said topographical pattern.

4. The method according to any of the preceding claims, wherein distributing the topographical pattern across a device area comprises covering the complete front side of said carrier element with said topographical pattern.

5. The method according to any of the preceding claims, wherein the step of passivating a peripheral part of said device area comprises:
providing an oxide mask on top of a portion of said device area;
oxidizing said front side of said carrier element; and
removing said oxide mask from said device area.

6. The method according to claim 5, wherein the step of providing an oxide mask comprises
providing a first layer of silicon nitride on top of said device area;
providing a resist layer on top of said layer of silicon nitride;
removing a peripheral part of said resist layer; and
etching through the first layer of silicon nitride using the remaining resist layer as an etch mask.

7. The method according to claim 6, wherein the step of etching through the first layer of silicon nitride is performed by an anisotropic process.

8. The method according to any of the preceding claims, further comprising the step of providing an annular recess at said peripheral part.

9. An ECPR master electrode (100, 300), comprising
a circular carrier element (101) having an electrically conducting electrode surface (106) on a back side (104) and a topographical pattern (107, 307) with an at least partly electrically insulating top (108) on a front side (105) of said carrier element (101),
said topographical pattern comprising a plurality of electrochemical cells (109) in said carrier element (101), each one of said electrochemical cells comprising a bottom (111) and at least one side wall (112), said bottom having an electrically conducting surface (113) being conductively connected to the electrically conducting electrode surface (106) on the back side (104) through the carrier element (101),
wherein
said topographical pattern (107, 307) is distributed across a circular device area (130, 301) comprising a plurality of rectangular chip areas (103), and a passivated area (140, 302) surrounding said device area (130, 301).

10. The ECPR master electrode according to claim 9, wherein said passivated area (140, 302) comprises an oxide layer (320) on top of said topographical pattern (107, 307).

11. The ECPR master electrode according to claim 8 or 9, wherein the carrier element (101) comprises an annular recess outside the passivated area (140, 302).

12. The ECPR master electrode according to claim 11, wherein said annular recess extends from the outer circular periphery of the passivated area (140, 302) to the edge of the carrier element (101).

## Patentansprüche

1. Verfahren zur Bereitstellung einer ECPR-Masterelektrode, umfassend den Schritt des:
Bereitstellens eines kreisförmigen Trägerelements, das eine elektrisch leitende Elektrodenfläche an einer Rückseite und ein topographisches Muster mit einer mindestens teilweise elektrisch isolierenden Oberseite an einer Vorderseite des Trägerelements aufweist, wobei das topographische Muster eine Vielzahl elektrochemischer Zellen in dem Trägerelement umfasst, wobei jede der elektrochemischen Zellen einen Boden und mindestens eine Seitenwand umfasst, wobei der Boden eine elektrisch leitende Oberfläche aufweist, die leitfähig mit der elektrisch leitenden Elektrodenfläche an der Rückseite durch das Trägerelement verbunden ist,
wobei der Schritt der Bereitstellung des topographischen Musters umfasst:
Verteilen des topographischen Musters über einen Vorrichtungsbereich, der sich radial von dem Zentrum des Trägerelements zu dem Außenumfang des Trägerelements erstreckt, und
Passivieren eines Umfangsteils des Vorrichtungsbereichs durch Anordnen einer elektrisch isolierenden Schicht oben auf dem Umfangsteil des Vorrichtungsbereichs.

2. Verfahren nach Anspruch 1, wobei die elektrisch isolierende Schicht eine Oxidschicht ist.

3. Verfahren nach Anspruch 1 oder 2, wobei das Verteilen des topographischen Musters über einen Vorrichtungsbereich die Bereitstellung einer Vielzahl rechteckiger Chipflächen umfasst, wobei jede Chipfläche einen Teil des topographischen Musters bildet.

4. Verfahren nach einem der vorgenannten Ansprüche, wobei das Verteilen des topographischen Musters über einen Vorrichtungsbereich das Bedecken der gesamten Vorderseite des Trägerelements mit dem topographischen Muster umfasst.

5. Verfahren nach einem der vorgenannten Ansprüche, wobei der Schritt des Passivierens eines Umfangsteils des Vorrichtungsbereichs umfasst:
Vorsehen einer Oxidmaske oben auf einem Teil des Vorrichtungsbereichs;
Oxidieren der Vorderseite des Trägerelements; und
Entfernen der Oxidmaske von dem Vorrichtungsbereich.

6. Verfahren nach Anspruch 5, wobei der Schritt des Bereitstellens einer Oxidmaske umfasst
Vorsehen einer ersten Schicht Siliziumnitrid oben auf dem Vorrichtungsbereich;
Vorsehen einer Resistschicht oben auf der Schicht Siliziumnitrid; Entfernen eines Umfangsteils der Resistschicht; und
Ätzen durch die erste Schicht Siliziumnitrid unter Verwendung der verbleibenden Resistschicht als Ätzmaske.

7. Verfahren nach Anspruch 6, wobei der Schritt des Ätzens durch die erste Schicht Siliziumnitrid mittels einen anisotropen Prozesses durchgeführt wird.

8. Verfahren nach einem der vorgenannten Ansprüche, weiter den Schritt des Vorsehens einer ringförmigen Ausnehmung an dem Umfangsteil umfassend.

9. ECPR-Masterelektrode (100, 300), umfassend:
ein kreisförmiges Trägerelement (101), das eine elektrisch leitende Elektrodenfläche (106) an einer Rückseite (104) und ein topographisches Muster (107, 307) mit einer mindestens teilweise elektrisch isolierenden Oberseite (108) an einer Vorderseite (105) des Trägerelements (101) aufweist,
wobei das topographische Muster eine Vielzahl elektrochemischer Zellen (109) in dem Trägerelement (101) umfasst, wobei jede der elektrochemischen Zellen einen Boden (111) und mindestens eine Seitenwand (112) umfasst, wobei der Boden eine elektrisch leitende Oberfläche (113) aufweist, die leitfähig mit der elektrisch leitenden Elektrodenfläche (106) an der Rückseite (104) durch das Trägerelement (101) verbunden ist,
wobei
das topographische Muster (107,307) über einen kreisförmigen Vorrichtungsbereich (130, 301), der eine Vielzahl rechteckiger Chipflächen (103) umfasst, und einen diesen Vorrichtungsbereich (130, 301) umgebenden passivierten Bereich (140, 302) verteilt ist.

10. ECPR-Masterelektrode nach Anspruch 9, wobei der passivierte Bereich (140, 302) eine Oxidschicht (320) oben auf dem topographischen Muster (107, 307) umfasst.

11. ECPR-Masterelektrode nach Anspruch 8 oder 9, wobei das Trägerelement (101) eine ringförmige Ausnehmung außerhalb des passivierten Bereichs (140, 302) umfasst.

12. ECPR-Masterelektrode nach Anspruch 11, wobei die ringförmige Ausnehmung sich von dem äußeren kreisförmigen Umfang des passivierten Bereichs (140, 302) bis zu dem Rand des Trägerelements (101) erstreckt.

## Revendications

1. Procédé pour procurer une électrode-maître EC PR, comprenant l'étape consistant à :
procurer un élément de support circulaire possédant une surface d'électrode électroconductrice sur le côté dorsal et un motif topographique comprenant une couverture au moins partiellement électriquement isolante, sur le c ô té frontal dudit élément de support, ledit motif topographique comprenant plusieurs cellules électrochimiques dans ledit élément de support, chacune desdites cellules électrochimiques comprenant une base et au moins une paroilatérale, ladite base possédantune surface électroconductrice reliée par conduction à la surface d'électrode électroconductrice sur le côté dorsalvia l'élémentde support,
l'étape consistant à procurer ledit motif topographique comprenantle fait de :
distribuer ledit motif topographique à travers une zone de dispositif s'étendant en direction radiale à partir du centre de l'élément de support en direction de la périphérie dudit élément de support; et
rendre passive une partie périphérique de ladite zone de dispositif en arrangent une couche électriquement isolante par dessusladite partie périphérique de ladite zone de dispositif.

2. Procédé selon la revendication 1, dans lequel ladite couche électriquement isolante estune couche d'oxyde.

3. Procédé selon la revendication 1 ou 2, dans lequel la distribution du motif topographique à travers une zone de dispositif comprend le fait de procurer plusieurs surfaces occupées rectangulaires, chaque surface occupée formant une portion dudit motif topo graphique.

4. Procédé selon l'une quelconque des revendications précédentes, dans lequel la distribution du motif topographique à travers une zone de dispositif comprend le recouvrement du côté frontal complet dudit élément de support avec ledit motif topographique.

5. Procédé selon l'une quelconque des revendications précédentes, dans lequel l'étape de passivation d'une partie périphérique de ladite zone de dispositifcomprend le faitde :
procurer un masque pour l'oxydation par dessus une portion de ladite zone de dispositif;
oxyder le dit côté frontal dudit élément de support ; et
retirer de ladite zone de dispositif ledit masque pour l'oxydation.

6. Procédé selon la revendication 5, dans lequel l'étape consistant à procurer un masque pour l'oxydation comprend le fait de :
procurer une première couche de nitrure de silicium par-dessus ladite zone de dispositif;
procurer une couche de résine par-dessus ladite couche de nitrure de silicium ;
retirer une partie périphérique de ladite couche d'agent de réserve ; et
procéder à une gravure à travers la première couche de nitrure de silicium en utilisant la couche restante de résine comme masque de gravure.

7. Procédé selon la revendication 6, dans lequel l'étape consistant à procéder à une gravure à travers la première couche de nitrure de silicium estmise en oeuvre via un procédé anisotrope.

8. Procédé selon l'une quelconque des revendications précédentes, comprenant en outre l'étape consistant à procurer un évidement annulaire à ladite partie périphérique.

9. Electrode-maître ECPR(100, 300) comprenant:
un élément de support circulaire (101) possédant une surface d'électrode électroconductrice (106) sur le côté dorsal (104) et un motif topographique (107, 307) comprenant une couverture (108) au moins partiellement électriquement isolante sur le côté frontal (105) dudit élément (101) faisant office de support;
ledit motif topographique comprenant plusieurs cellules électrochimiques (109) dans ledit élément (101) de support, chacune desdites cellules électrochimiques comprenant une base (111) et au moins une paroi latérale (112), ladite base possédant une surface électroconductrice (113) reliée par conduction à la surface d'électrode électroconductrice (106) sur le côté dorsal (104) via l'élément (101) de support;
ledit motif topographique (107, 307) étant distribué à travers une zone circulaire de dispositif (130, 301) comprenant plusieurs zones occupées rectangulaires (103) et une zone qui a été rendue passive (140, 302) entourant ladite zone de dispositif (130, 301).

10. Electrode-maître ECPR selon la revendication 9, dans laquelle ladite zone qui a été rendue passive (140, 302) comprend une couche d'oxyde (320) par-dessus ledit motif topographique (107, 307).

11. Electrode-maître ECPR selon la revendication 8 ou 9, dans laquelle l'élément (101) de support comprend un évidement annulaire à l'extérieur de la zone quia été rendue passive (140, 302).

12. Electrode-maître ECPR selon la revendication 11, dans laquelle ledit évidement annulaire s'étend depuis la périphérie circulaire externe de la zone qui a été rendue passive (140, 302) jusqu'au bord de l'élément (101) de support.
